# EUROPEAN PATENT SPECIFICATION

(11) **EP 1 717 334 B1**
(45) Date of publication and mention of the grant of the patent: **27.02.2013**
(21) Application number: 06009092.5
(22) Date of filing: 02.05.2006
(51) Int. Cl.: C23C 14/18

(54) **Method for producing optically transparent noble metal films**
Verfahren zur Abscheidung von optisch transparenten Metallbeschichtungen
Méthode de dépôt de films métalliques minces optiquement transparents

(30) Priority: 29.04.2005 EP 05009460
(43) Date of publication of application: 02.11.2006
(60) Divisional application: 10182108.0
(73) Proprietor: STMicroelectronics Srl, 20864 Agrate Brianza (IT)
(72) Inventor: Conoci, Sabrina, 95030 Tremestieri Etneo (Catania) (IT); Petralia, Salvatore, 97015 Modica (Ragusa) (IT)
(74) Representative: Ferrari, Barbara

(56) References cited:
- US-A- 4 400 255
- HECQ M ET AL: "X-RAY DIFFRACTION STUDIES OF SPUTTERED THIN FILMS OF PLATINUM" JOURNAL OF APPLIED PHYSICS, AMERICAN INSTITUTE OF PHYSICS. NEW YORK, US, vol. 53, no. 1, January 1982 (1982-01), pages 421-427, XP001031078 ISSN: 0021-8979 & KOJIMA ET AL: "Structure and electrical property of platinum film biased DC-sputter-deposited on silicon" APPLIED SURFACE SCIENCE, vol. 169-170, 15 January 2001 (2001-01-15), pages 320-324, XP002346981 NL
- MEI X ET AL: "MICRO-STRUCTURE AND ELECTRICAL PROPERTIES OF NANOCRYSTALLINE PT THIN FILM PREPARED BY R.F. SPUTTERING" MATERIALS RESEARCH SOCIETY SYMPOSIUM PROCEEDINGS, MATERIALS RESEARCH SOCIETY, PITTSBURG, PA, US, vol. 286, 1993, pages 179-194, XP008052735 ISSN: 0272-9172
- GENTNER T H ET AL: "Growth, morphology and annealing of thin Co layers on Au/mica" THIN SOLID FILMS, ELSEVIER-SEQUOIA S.A. LAUSANNE, CH, vol. 275, no. 1, 1 April 1996 (1996-04-01), pages 58-60, XP004006922 ISSN: 0040-6090
- KLAUK H ET AL: "Ion-beam-deposited ultrathin transparent metal contacts" THIN SOLID FILMS, ELSEVIER-SEQUOIA S.A. LAUSANNE, CH, vol. 366, no. 1-2, May 2000 (2000-05), pages 272-278, XP004203869 ISSN: 0040-6090
- THOMAS JOHN H: "Effect of pressure on dc planar magnetron sputtering of platinum" JOURNAL OF VACUUM SCIENCE AND TECHNOLOGY A. VACUUM, SURFACES AND FILMS, AMERICAN INSTITUTE OF PHYSICS, NEW YORK, NY, US, vol. 21, no. 3, May 2003 (2003-05), pages 572-576, XP012006336 ISSN: 0734-2101

## Description

### Field of application

The present invention relates, in its more general aspect, to components for electronics applications having properties of optical transparency and electrical conductivity.

In particular the present invention relates to a method for producing optically transparent platinum films, and especially a method of the type comprising a step of sputtering platinum on a substrate.

The present invention also relates to a composite structure comprising a substrate and a platinum film formed on said substrate.

### Prior art

The achievement of optically transparent, electrically conductive films of noble metals on transparent substrates represents an interesting technological task. Such films would have the advantage to be used as transparent materials having the characteristics of noble metals.

This is of interest both for traditional and emerging technologies, such as molecular electronics and opto-electronics.

In particular, beyond traditional applications as metal electrodes or conducting substrates, optically transparent noble metal films allow the development of the emerging molecular nanotechnology, through the self-assembly of molecule-based materials.

In other words, noble metal films arc suitable for use as substrate for self-assembled molecular layers.

In fact, optically transparent noble metal films show the considerable advantage that their optical properties or those of an assembled molecular layer can be simply monitored by UV/Vis transmission spectroscopy.

In this last regard, ultra-thin gold films have recently been reported as semitransparent metal substrates (M. Wanunu, et al., J. Am. Chem. Soc. 2004, 126, 5569-5576). Their use and applicability as conductive and transparent materials are, however, rather limited by the presence of absorption related to the plasmon resonance of gold nanoparticle layers.

From U.S. Pat. No. 4,273,624, issued in 1981 to H. A. Laitinen; D. C. Thornton, a method for making the deposition of transparent platinum films is also known.

This patent relates to the electrodeposition of a thin platinum film on a conductive thin oxide substrate. However, in this patent no specific data or statements are reported about the actual transparency of these films, being the invention essentially directed to their electrochemical applications.

A simple method is also known, from some preliminary studies provided by the Applicant, for obtaining ultrathin platinum films having a good optical transparency in the UV-Vis region. The application of the platinum films thus obtained are suitable as substrates of self-assembly monolayers of molecular materials (S. Sortino, et al. J. Am. Chem. Soc. 2003, 125, 1122-1123; J. Mater. Chem. 2004, 14, 811-813).

In particular, this method discloses a sputtering step for carrying out the noble metal deposition.

This known method, although allowing a deposited film to be obtained, which exhibits a combination of good optical transparency and homogeneity, chemical and mechanical robustness, has however some still unsolved drawbacks.

The main drawback lies in that homogeneity, chemical and mechanical robustness and optical transparency of the deposited film are often not so high as to satisfy the requirements of some applications.

In particular, it is to be considered that the emerging applications, such as hybrid electrical and apto-electronic devices, keep on requiring further improvement of optical transparency, conductivity, homogeneity, chemical and mechanical robustness.

For this reason, there is the need of further improving the characteristics of the noble metal film in order to satisfy the requirements of any applications, also highly sophisticated applications such as electrical and opto-electronic devices, or transparent transistors.

Another method, on which the preamble of claim 1 is based, is known for example either from HECQ M..ET AL: "X-RAY DIFFRACTION STUDIES OF SPUTTERED THIN FILMS OF PLATINUM" JOURNAL OF APPLIED PHYSICS, AMERICAN INSTITUTE OF PHYSICS. NEW YORK, US, vol. 53, n°. 1;), or D. KOJIMA ET AL: "Structure and electrical property of platinum film biased DC-sputter-deposited on silicon" APPLIED SURFACE SCIENCE, vol. 169-170, 15 January 2001 (2001-01-15).

MEI X ET AL: "MICRO-STRUCTURE AND ELECTRICAL PROPERTIES OF NANOCRYSTALLINE PT THIN FILM PREPARED BY R.F. SPUTTERING" MATERIALS RESEARCH SOCIETY SYMPOSIUM PROCEEDINGS, MATERIALS RESEARCH SOCIETY, PITTSBURG, PA, US, vol. 286, 1993, pages 179-194, XP008052735 ISSN: 0272-9172 discloses methods for producing platinum metal films on a substrate by sputtering subjecting the films to a thermal treatment.

GENTNER T H ET AL: "Growth, morphology and annealing of thin Co layers on Au/mica" THIN SOLID FILMS, ELSEVIER-SEQUOIA S.A. LAUSANNE, CH, vol. 275, no. 1, 1 April 1996 (1996-04-01), pages 58-60, XP004006922 ISSN: 0040-6090 discloses flame annealing of gold films.

In view of the above-outlined drawbacks of the state of the art, the technical problem underlying the present invention is that of developing a method for producing optically transparent noble metal films also possessing characteristics of conductivity, chemical and mechanical robustness, purity, and homogeneity comparable to those of metal electrodes or bulky conductive metals.

### Summary of the invention

Such technical problem is solved, according to the invention, by a method for producing a platinum film as defined in annexed claim 1.

The flame treatment allows a ultra-thin noble metal film (having a thickness comprised between about 10 nm and about 30 nm) to be obtained, which exhibits good optical transparency in the UV region, low electrical resistance, better homogeneity, better chemical and mechanical robustness with respect to the prior art films and comparable to those of metal electrodes or bulky conductive metals.

Moreover the obtained ultra-thin film is fully suitable for use as a base of self-assembly molecule-based materials and in situ chemical synthesis, for example thiol-terminated molecule-based materials.

Preferred embodiments of the method according to the present invention are disclosed in dependent claims 2 to 9.

Further characteristics and advantages of the method according to the invention will be apparent from the following description of some embodiments thereof given by way of indicative and non limiting example with reference to the annexed drawings.

### Brief description of the drawings

In the drawings:
Figures 1A-1E are respective schematic views of an operative sequence of a first embodiment of the method according to the invention.
Figures 1F- 1L are respective schematic views of an operative sequence or a further embodiment of the method according to the invention.
Figure 2 shows a plot including three UV-VIS spectra of a Pt film, annealed Pt film (A2) and flamed Pt film (F1), respectively.
Figures 3A-3C show AFM (atomic force microscope) images of the Pt films, annealed Pt Film and flamed Pt film of figure 2 respectively.
Figures 4A-4C show an optical micrography of a Pt film before and after determined T1 and T2 chemical treatments respectively.
Figures 5A-5C show an optical micrography of an annealed Pt film before and after determined T1 and T2 chemical treatments respectively.
Figures 6A-6C show an optical micrography of a flamed Pt film before and after determined T1 and T2 chemical treatments respectively.

### Detailed description

With reference to the annexed drawings, reference number 10 globally indicates a scheme of a method for the production of a noble metal film on a substrate 14.

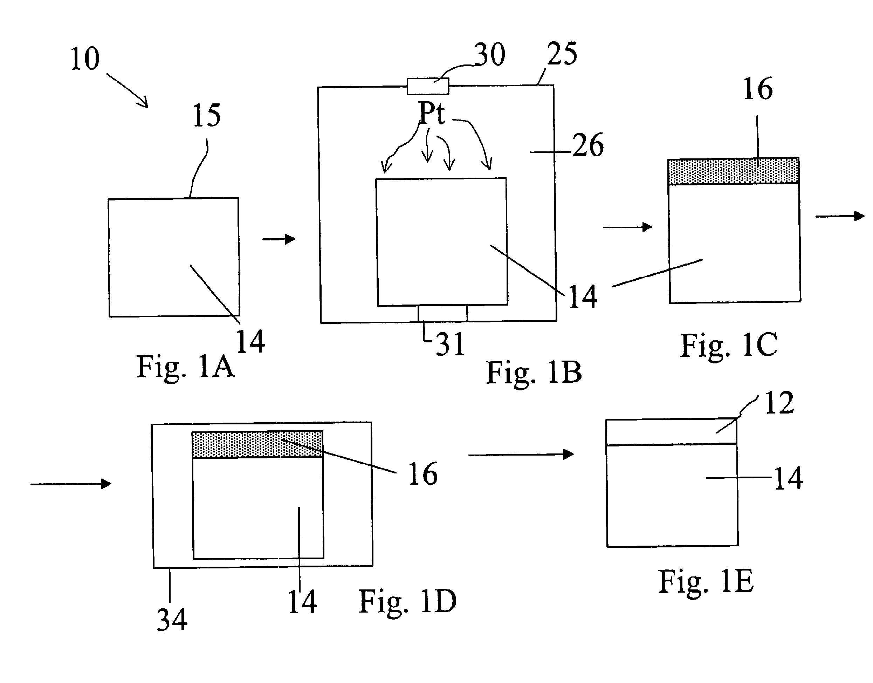

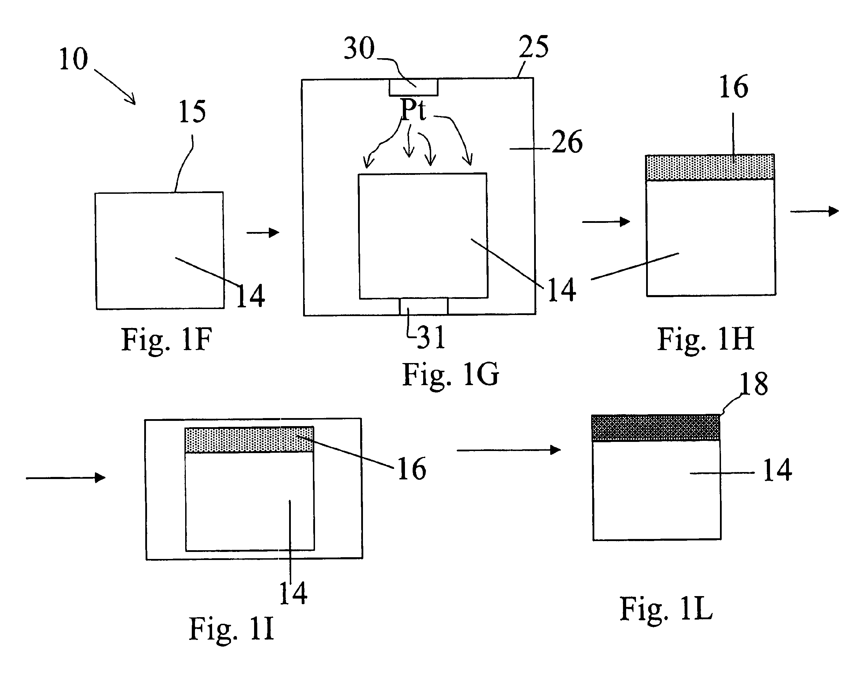

In particular, according to figures 1A to 1E and figures 1F to 1L, the noble metal film thus produced is indicated either with reference number 12 or reference number 18.

The noble metal film 12, 18 thus obtained is suitable for use as a part of electronic devices, i.e. electrodes, solar cells, touch display panels, flat panel displays, transparent transistors, optical and antistatic coatings, hybrid electrical and opto-electronic devices based on molecular or bio-molecular films.

The method steps and the structures hereafter described are not a complete process flow for the manufacturing of the above devices.

In fact, the embodiments can be put into practice with the manufacturing techniques currently used in the field of any of the above devices and hereafter only those commonly used method steps are described which are necessary for the comprehension of the embodiments.

The figures showing cross sections of the noble metal film 12, 18 formed on the substrate 14 during the manufacturing are not drawn to scale, but they are instead drawn so as to show the important features of the embodiments.

The method comprises the main steps of
- sputtering a noble metal on a surface 15 of the substrate 14 thus obtaining an film 16 and
- subjecting the film 16 to a thermal treatment, thus obtaining a heated metal film 12, 18.

Preferably, the thermal treatment is carried out at a temperature of at least 300°C.

In other words, the method provides a heating treatment of the film 16, which ensures an optimization of the optical transparency, conductivity, homogeneity, chemical and mechanical robustness of the film.

After the thermal treatment a composite structure comprising the substrate 14 and the film 12, 18 is obtained.

The results obtained by the process can be explained from a physical point of view as follows.

The thermal treatment provokes an improvement in the connection between metal grains giving rise to consequent optimised properties.

In the described embodiment the noble metal is platinum and the substrate 14 is a glass slide substrate, but it could also be made of another transparent material such as quartz, which similarly to the glass substrate is not atomically flat and has a rough surface.

The optical transparent substrate 14 has the advantage of enabling the detection of the optical properties of the composite structure by UV/VIS transmission spectroscopy.

In a first embodiment, the method includes the following steps (see figures 1A-1E).

In a first step, platinum is sputtered on the substrate 14, for example by means of a sputtering system 25, for example an Emitech K650X Sputtering Coater.

This system 25, which is schematically shown in figure 1B, comprises a sputter chamber 26 having, on top, a negative cathode made of the target material to be sputtered, i.e. platinum.

On the bottom of this chamber 26, at a distance of about 6 cm from the cathode, an anode plate is located where the substrate 14 is placed and that is usually "earthed" to the system.

The cathode and the anode are schematically illustrated in figure 1R with reference numbers 30 and 31 respectively.

Moreover, the system 25 operates under argon atmosphere. In other words, the chamber 26 is kept under argon atmosphere.

Preferably, the chamber 26 is set under an operating pressure, also called relative vacuum, of about 1 x 10⁻¹ mbar. The above desired operating pressure is obtained by means of a suitable applied vacuum, usually a two stage rotary pump (not shown).

The inert gas, such as argon in the present embodiment, is admitted to the chamber 26 by a fine control valve (2 x 10⁻¹ mbar). Not even the valve is shown in the drawings.

It is to be noticed that the above system 25 is suitable for sputtering platinum at the same time on a plurality of substrates 14.

However, for sake of conciseness, hereafter in the description the method is disclosed with reference to a single substrate 14.

In any case, it is to be understood that the following steps can be performed also for sputtering platinum on a plurality of substrates 14.

In the illustrated case, the surface size of each substrate, on which platinum is spattered, is of about 1 cm x 2 cm. As above mentioned, either glass or quartz can be used as transparent substrate 14.

Preferably, before introducing the substrate 14 into the chamber 26, the substrate 14 is first sonicated for 180 sec in a 2-H propanol bath and then dried in an oven at 80°C for 30 min.

The substrate 14 is then introduced into the sputtering system 25.

Successively, a suitable voltage is applied on the electrodes, namely the anode 30 and the cathode 31, and a glow discharge is generated in the chamber 26. This operation determines the sputtering of platinum and therefore the deposition of platinum on the substrate 14.

Under the above conditions, the sputtering step preferably involves a sputtering time of 165 s with a current of 75 mA.

After deposition on the substrate 14, the above-cited film 16 is thus obtained.

Subsequently, the film 16 is extrarted from the sputtering system 25 and kept at room temperature in an appropriate sample-tray.

In particular, under the above-described conditions, the sputtering step produces a platinum film 16 having an average thickness of 25 nm.

This measure of thickness is obtained as result of a SEM analysis (Scanning electron microscope) carried out by means of a LEO 1550 Instrument operating at 5 kV. A micrography of the Pt/substrate interface is obtained by tilting the sample of about 18°.

Afterwards, the film 16 is monitored by UV/VIS transmission spectroscopy, in order to assess its optical transmittance.

From the analysis, it has emerged that the optical transmittance always ranges from 70% to 90% in the 300-800 nm spectral region.

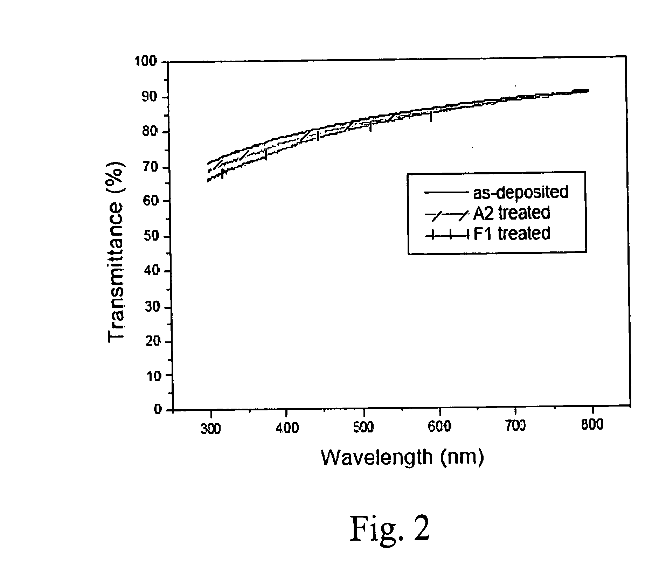

Figure 2 illustrates the UV-VIS spectrum of the Pt film 16. More details of the UV-VIS spectra of figure 2 are reported hereafter in the description.

As it is known, optical transmittance depends on the thickness of the film 16. As a consequence, it is to be understood that the longer is the sputtering time, the thicker will be the film 16 and the lower the optical transparency.

It is also to be noticed that the above-described conditions are chosen since they are considered as a good compromise to obtain films having at the same time good electrical and morphological characteristics and a very good optical transparency.

The morphological characteristics of the film 16 have been monitored by means of an atomic force microscope (AFM). In particular the measurements have been made by means of a Digital 3100 Instrument, which adopts a tapping mode analysis.

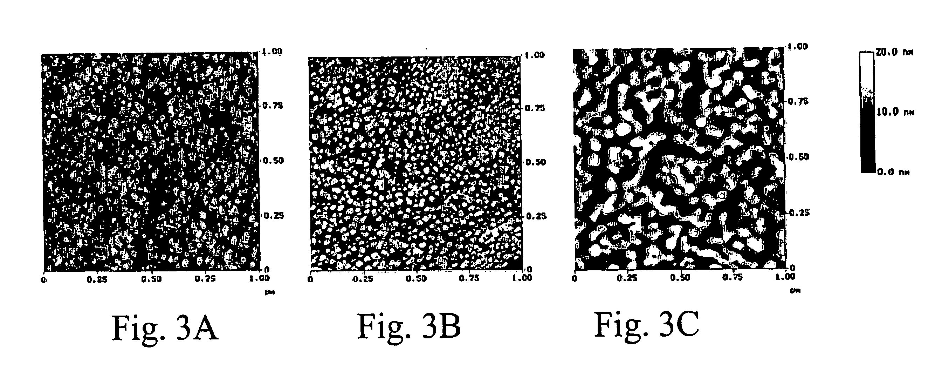

In figure 3A an AFM image is illustrated, which shows that the film 16 consists of homogeneously distributed polycrystals, which have the following size: lateral size comprised between about 25 and about 30 nm and height comprised between 2 and 5 nm.

The related Root Mean Square Roughness (RMS) is 1.75 nm.

The mechanical properties of the film 16 have also been measured.

To do this, the resistivity of the film 16 has been measured by a known Four-Point Probe method.

This method has been carried out by using a linear array arrangement, probe-tips of wolframium of 2 µm radius, 1 mm spaced, connected to an Agilent 4155C Semiconductor Parameter Analyzer and to a FLUKE 85 series III RMS Multitester voltage measure.

The results have shown average values of 690×10⁻⁶ Ω cm.

As above-mentioned, in order to improve the above-described homogeneity, chemical and mechanical robustness of the film 16, the latter is subjected to thermal treatment. In this embodiment the thermal treatment comprises an annealing treatment.

The annealing treatment provides the step of heating the film 16 in an annealing oven 34, preferably in presence of air.

From the annealing treatment an annealed platinum film 12 is thus obtained.

In the present embodiment, the annealing treatment involves a heating at 350 °C for 12 h, with the oven 34 being heated at a heating rate of 5 °C/min. Air-cooling is then applied for cooling the oven 34.

According to an aspect of this disclosure, at this point the film 12 is still highly transparent (optical transmittance > 70%). Figure 2 illustrates the UV-VIS spectrum in the 300-800 nm spectral region of the annealed platinum film 12.

In particular, in figure 2, annealed platinum film 12 is denoted with reference sign A2.

It is to be noted that the annealed platinum film 12 shows a higher absorption in the UV-VIS spectral region than the film 16.

It has also been observed that the annealed platinum film 12 has a better homogeneity, larger conductivity, and higher chemical and mechanical robustness, than the film 16.

The above characteristics have been measured as follows.

The morphological characteristics of the annealed platinum film 12 have been monitored, as for the film 16, by means of an AFM.

In particular, figure 3B illustrates an AFM image, which shows that the annealed platinum film 12 consists of polycristals having the following sizes: lateral size comprised between 40 and 70 nm, and height comprised between 9 and 10 nm. The related Root Mean Square Roughness (RMS) is about 3.7 nm.

An increase of the values with respect the film 16 is thus obtained.

Also the electrical and mechanical properties of the annealed platinum film 12 have been measured and compared with those of the film 16.

For this purpose, the resistivity of the annealed platinum film 12 has been measured according to the above-mentioned Four-Point Probe method.

In carrying out this method the same operative conditions as for the film 16 have been used.

From the measurements, average values of 346×10⁻⁶ Ω cm of the resistivity have been obtained.

A Transmission Electronic Microscopy (TEM) analysis of the annealed platinum film 12 has been also carried out to measure its thickness.

In particular, a cross-sectional view of the Pt/glass interface is obtained by using a Jeol JEM 2010 instrument operating at 200 kV; the measured thickness of the platinum film has been of 20 nm.

It can be noticed that the thickness of the annealed film 12 is lower than that of the film 16. This means that the annealed platinum film 12 is more compacted than the film 16 and appears to be without important porosity.

From the above results, it is confirmed that the thermal treatment, namely the annealing treatment, also leads to a remarkable chemical and mechanical robustness of the noble metal film.

In order to further show the improvement of the characteristics of the above film, both the annealed platinum 12 and the film 16 have been subjected to the following treatments:
i) sonication of the films 12 and 16 in CH₃OH bath, for 40 min, at room temperature; and
ii) immersion of films 12 and 16 in a CH₃OH bath, for 70 h, at 60°C.

These treatments arc examples of aggressive chemical conditions used during chemical reactions.

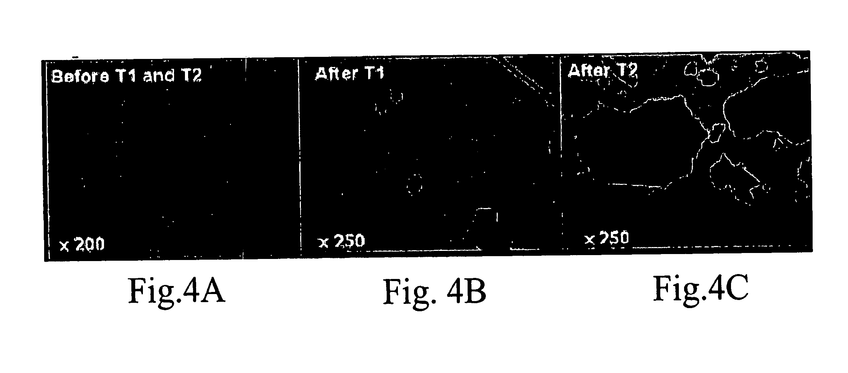

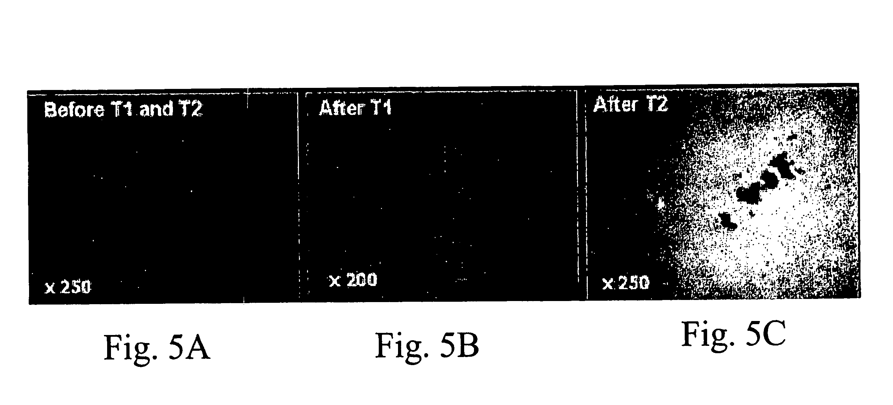

With reference to figures 4A-4C and figures 5A-5C the first treatment i) and the second treatment ii) are indicated with T1 and T2 respectively.

With reference to figures 4A-4C and figures 5A-5C, the film 16 and the annealed platinum film 12 have been analyzed by means of optical micrography analysis with an Olympus MX50 Instrument.

From the analysis, it results that some significant changes of the film 16 are involved before and after the above T1 and T2 treatments respectively, as shown in FIG. 4A-4C.

On the contrary, it results that no significant changes of the annealed platinum film 12 are involved before and after the above T1 and T2 treatments respectively, as shown in FIG. 5A-5C.

As a consequence, it has been proved that the annealed platinum film 12 is more suitable than the film 16 for undergoing chemical treatments enabling the possibility to achieve *in situ* chemical reactions for the preparation of self assembled monolayers on a variegated scale for the production of any of the above-mentioned devices.

In other words, it has been proved that the annealing step improves the properties of the film and enables the metal noble film 12 to be subjected to chemical reactions.

Moreover, in order to further monitor the characteristics of the annealed film 12, an assessment of its physical adhesion on the glass-slide substrate 14 has been made.

To do this, linear scratch tests obtained by a Nano Hardness Tester with Open Platform CSM Instrument have been carried out. The operative conditions have been as follows: progressive load 0.2-1 mN; diamond Rockwell-type indenter of 5 µm radius; run length 1 mm.

First events of damage (minor cricks) appear at higher load (0.73 mN) with respect to the film 16 (0.58 mN), thus indicating a better adhesion upon annealing treatment.

In a further embodiment, the method comprises the following steps (figures 1F 1L).

In a first step platinum is sputtered on the substrate 14 thus obtaining the film 16. The sputtering step has been performed according to the operative conditions, which have been described for the first embodiment of the method.

In the present embodiment, the method comprises a step of flaming the film 16 to further improve the overall characteristics of the film.

In other words, in this further embodiment, the thermal treatment comprises a step of flaming the film 16.

In particular the film 16 has been subjected to a flaming treatment for a determined period. For sake of clarity, the film obtained from the flaming treatment is hereafter defined as flamed film 18.

The flaming treatment is carried out after the sputtering step and it is carried out for 30 sec by using a butane-flam apparatus.

In particular, the known flaming apparatus FLAME CONTROL "Poligos" (Vallini G., Senago (MI), CAT. Number: 785) has been used.

It has been estimated that, in the case of butane-flam, the flaming temperature of the film is comprised between 1000 - 1200 °C.

Hereafter, the results of the optical, chemical, mechanical and electrical tests, which have been performed on the flamed film 18, are reported.

In particular, the flamed film 18 is still transparent (optical transmittance > 70%). Figure 2 illustrates the UV-VIS spectrum in the 300-800 nm spectral region of the flamed film.

In particular, in figure 2, flamed film 18 is denoted with reference sign F1.

It is to be noted that the flamed film 18 has a higher absorption in the UV VIS spectral region than the film 16.

The flamed film 18 haa also larger conductivity, and higher chemical and mechanical robustness, than the film 16.

In particular, the flamed film 18 has been subjected to the above-mentioned AFM analysis. The flamed film 18 shows an increase of the size of polycrystals, namely lateral size of 40÷100 nm, and height of 11÷20 nm. The related Root Mean Square Roughness (RMS) is of 5.3 nm.

The AFM also indicates the formation of a network of "worm-like" platinum film on the substrate 14. It is to be remarked that the expression "worm-like" is to be intended as a pictorial description on the aspect of the Pt film microstructure after flaming treatment (film 18).

The above-mentioned TEM analysis of the flamed film for measuring its thickness has been also carried out. In particular, the cross-sectional view of the Pt/substrate 14 interface is obtained by using a Jeol JEM 2010F instrument operating at 200 kV.

The TEM analysis indicates a thickness of 18 nm. Also the mechanical properties of the flamed film 18 have been measured and compared with the film 16.

To do it, the resistivity of the flamed film 18 has been measured according the above-mentioned Four-Point Probe method.

The resistivity of the flamed film shows average values of 39×10⁻⁶ Ω cm, being very close and comparable to that measured for bulk platinum (10×10⁻⁶ Ω cm).

The flaming treatment also leads to a remarkable chemical and mechanical robustness.

For further showing the properties of the flamed film, this latter has been subjected to the above-cited treatments T1 and T2, namely: sonication of the flamed film in CH₃OH bath, for 40 min, at room temperature (T1); and immersion in a CH₃OH bath, for 70 h, at 60°C (T2).

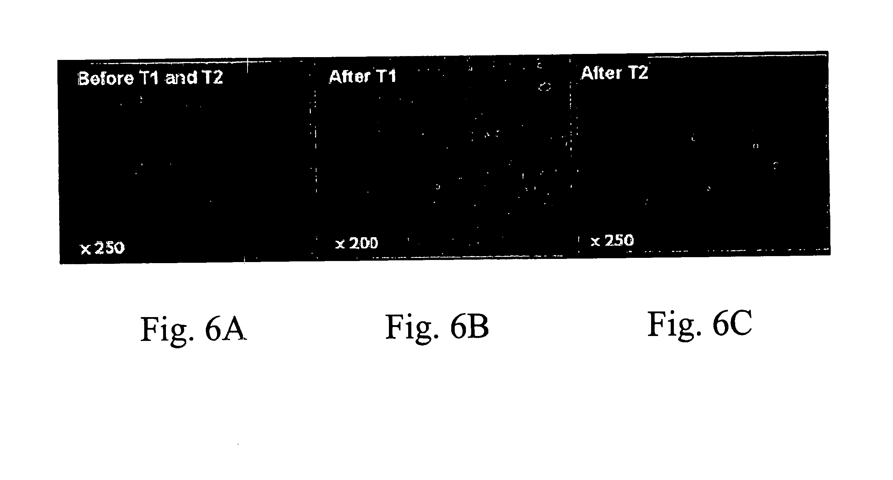

With reference to figures 6A-6C, it has been proved that no changes are involved before and after the above T1 and T2 treatments, as shown by optical micrography analysis carried out by an Olympus MX50 Instrument.

As a consequence, it has been proved that the flamed film 18 is more suitable than the film 16, even than the annealed film 12, for undergoing chemical treatments enabling the possibility to achieve *in situ* chemical reactions for the preparation of self assembled monolayers on a variegated scale for the production of any of the above-mentioned devices.

In other words, it has been proved that the flaming step improves the properties of the film and enables the flamed film 18 to be subjected to chemical reactions.

Moreover, in a further analysis, the physical adhesion of the flamed film 18 on the glass-slide substrate 14 has been also assessed. Also in this case, the same operative conditions as for the annealed film 12 have been used to carry out the analysis.

First events of damage (minor cricks) appear at the applied load of 0.98 mN, corresponding almost to the final value (1 mN).

It is to be noticed that the applied load (0.98 m) is higher than that of the annealed film 12, thus indicating a better adhesion upon flaming treatment.

All the results discussed above are summarized as follows:

**Table 1**

| | Film As- prepared (sputtered) | Method 1: Film Annealed at 350°C 12h | Method 2: Film Flamed |
|---|---|---|---|
| Thickness | 25 nm | 20 nm | 18 nm |
| Transmittance 300-800 nm | 70-90% | > 70% | >70% |
| Resistivity | 690 10⁻⁶ Ω cm | 346 10⁻⁶ Ω cm | 39 10⁻⁶ Ω cm (very close to Pt bulk 10 10⁻⁶ Ω cm) |
| Adhesion (Load for minor cricks) | 0.58 mN | 0.73 mN | 0.98 mN |
| Mechanical Resistance to chemical treatment T1 | Very Poor | Good | Very Good |
| Mechanical Resistance to chemical treatment T2 | Very Poor | Good | Very Good |

In the last specific embodiment, a composite structure is obtained wherein the noble metal film consists of polycrystals having the following properties:
- lateral size of polycrystals comprised between 70 and 100 nm;
- height of polycrystals comprised between about 1 and 20 nm;
- Root Mean Square Roughness of polycrystals of about 5,3 nm;
- resistivity having an average value of 39×10⁻⁶ Ω cm.
- load resistance of 0,98 mN.

It is to be noticed that resistivity value of 39x 10⁻⁶ Ω cm is very close to that measured for bulk platinum (10×10⁻⁶ µΩ cm).

It is also to be remarked that the load resistance is referred to the maximum load that can be applied to the film during the scratch test (mechanical test) before that the first surface damage event (minor cricks) occurs.

The metal noble film of the above composite structure is suitable for covalently anchoring organic molecules or bio-molecules in order to prepare molecular self assembled layers of organic molecules or molecular self assembled layers of bio-molecules. The molecules comprise:
- thiol-terminated chemical groups - SH; or
- thioethers chemical groups -SR, where R are alkyl groups.

Moreover, the metal noble film of the above composite structure is suitable for selectively adsorbing chemical species such as carbon monoxide.

The main advantage stays in that, thanks to the combination of the sputtering step and the thermal treatment, an ultra-thin noble metal film suitable for use as base for self-assembled molecular layers (and preferably having a thickness comprised between 10 and 30 nm) is produced, which offers a unique combination of properties making them well-suited to be employed in a variegated range of applications.

In particular, thanks to the combination of the sputtering step and the thermal treatment, the noble metal film has mechanical and electrical properties similar to those of bulk noble metals.

Another advantage is that of obtaining a metal noble film without important porosity.

Moreover, the use of platinum as noble metal offers the advantage that ultra-thin Pt films exhibit the plasmon absorption (ca 260 nm) in the extreme UV region, thus exhibiting optical transparency in almost the whole UV-VIS region.

In this context, apart from the conventional applications (such as transparent metal electrodes, solar cells, touch display panels, flat panel displays, transparent transistors, optical and antistatic coatings, ctc.) platinum film is particularly indicated in applications for hybrid electrical and optoelectronic devices based on molecular or biomolecular films.

Indeed, in this concern, the main advantages offered by Pt based composite structures are the molecular self-assembly of thiol-derivatives by covalent binding.

Moreover the resistivity of platinum film is very close to that measured for bulk platinum.

Moreover, Pt is preferred to more employed Au because it is compatible with silicon (Si CMOS technology), allowing integration with conventional Si CMOS technology for the production of hybrid molecular devices.

In addition, the mechanical robustness and the resistance towards chemical agents of such metal noble films and preferably Pt films allow the preparation of mono- and multiplayer molecular films, by molecular self-assembling, that can be further chemically modified by appropriate *in situ* chemical reactions.

This offers high flexibility in the preparation of molecular systems chemisorbed on these Pt films.

Moreover, the optical transparency and low electrical resistance of such Pt-based composite structure allow the simultaneous monitoring of optical and electrical properties of molecular films thus enabling their employment in optoelectronics applications.

Another advantage lies in that the method requires a reduced number of the steps necessary for the realisation of the noble metal film, and a simplification of the traditionally used tools.

Thermal treatments in fact comprise already consolidated techniques, i.e. annealing or flaming treatments, which ensure a high reproducibility.

It follows that the method according to embodiments of the invention is cheap and at the same time ensures reproducible films to be obtained.

Obviously, a technician of the field, in order to satisfy contingent, specific needs will bring several modifications and variations to the above described method, all within the scope of protection of the embodiments of the invention as defined by the following claims.

## Claims

1. Method for producing a noble metal film (12, 18), comprising the step of sputtering a noble metal on a substrate (14) made of an optically transparent material thus obtaining a film (16) of noble metal, wherein the noble metal is platinum, and the step of subjecting said film (16) to a thermal treatment, thus obtaining said noble metal film (12, 18), **characterized in that** the thermal treatment comprises a step of flaming the film (12, 18) of platinum, the flaming step involving a heating at a temperature comprised between 1000 and 1200°C and being carried out for 30 sec.

2. Method according to claim 1, wherein the flaming step is performed by means of a butane flame.

3. Method according to any one of claims 1 or 2, wherein, after the thermal treatment, the metal noble film (12, 18) is sonicated in CH₃OH bath at room temperature.

4. Method according to claim 3, wherein the metal noble film (12, 18) is sonicated for at least 30 min, preferably 40 min.

5. Method according to any one of claims 1 to 4, wherein, after the thermal treatment, the metal noble film (12, 18) is immersed in a CH₃OH bath at a temperature of at least 50°C, preferably of 60°C.

6. Method according to claim 5, wherein the metal noble film (12, 18) is immersed in the CH₃OH bath for at least 50 h, preferably 70 h.

7. Method according to claim 1, wherein the sputtering step is performed under inert gas atmosphere.

8. Method according to claim 1, wherein during the sputtering step the film (12) is located in a sputter chamber (26) having a negative cathode (30) which is made of the noble metal to be sputtered and an anode (31) plate on which the substrate (14) is placed.

9. Method according to claim 8, wherein the chamber (26) is under a set relative vacuum, of about 1 x 10⁻¹ mbar.

10. Method according to any one of claims 1 to 9, wherein, before said sputtering step, the substrate (14) is first sonicated and then dried.

## Patentansprüche

1. Verfahren zum Erzeugen eines Edelmetallfilms (12, 18), aufweisend den Schritt des Aufsputterns eines Edelmetalls auf ein Substrat (14), das aus einem optisch transparentem Material hergestellt ist, wodurch ein Film (16) aus Edelmetall erhalten wird, wobei das Edelmetall Platin ist, und den Schritt des Unterziehens des Films (16) einer thermischen Behandlung, wodurch der Edelmetallfilm (12, 18) erhalten wird, **dadurch gekennzeichnet, dass** die thermische Behandlung einen Schritt des Beflammens des Films (12, 18) aus Platin aufweist, wobei der Beflammschritt ein Erhitzen bei einer Temperatur, die zwischen 1000 und 1200°C liegt, umfasst und 30 Sekunden lang durchgeführt wird.

2. Verfahren nach Anspruch 1, bei dem der Beflammschritt mittels einer Butanflamme ausgeführt wird.

3. Verfahren nach einem der Ansprüche 1 oder 2, bei dem der Edelmetallfilm (12, 18) nach der thermischen Behandlung in einem CH₃OH-Bad bei Raumtemperatur beschallt wird.

4. Verfahren nach Anspruch 3, bei dem der Edelmetallfilm (12, 18) mindestens 30 Minuten lang, bevorzugt 40 Minuten lang, beschallt wird.

5. Verfahren nach einem der Ansprüche 1 bis 4, bei dem der Edelmetallfilm (12, 18) nach der thermischen Behandlung in ein CH₃OH-Bad mit einer Temperatur von mindestens 50°C, bevorzugt 60°C, eingetaucht wird.

6. Verfahren nach Anspruch 5, bei dem der Edelmetallfilm (12, 18) mindestens 50 h lang, bevorzugt 70 h lang, in das CH₃OH-Bad eingetaucht wird.

7. Verfahren nach Anspruch 1, bei dem der Schritt des Sputterns unter Inertgas-Atmosphäre ausgeführt wird.

8. Verfahren nach Anspruch 1, bei dem sich der Film (12) während des Schritts des Sputterns in einer Sputterkammer (26) mit einer negativen Kathode (30), die aus dem aufzusputternden Edelmetall hergestellt ist, und einer Anodenplatte (31), an der das Substrat (14) angebracht wird, befindet.

9. Verfahren nach Anspruch 8, bei dem sich die Kammer (26) unter einem eingestellten relativen Vakuum von etwa 1 x 10⁻¹ mbar befindet.

10. Verfahren nach einem der Ansprüche 1 bis 9, bei dem das Substrat (14) vor dem Schritt des Sputterns zuerst beschallt und dann getrocknet wird.

## Revendications

1. Procédé pour fabriquer un film de métal précieux (12, 18), comprenant une étape consistant à pulvériser un métal précieux sur un substrat (14) fait d'un matériau optiquement transparent pour obtenir ainsi un film (16) de métal précieux, le métal précieux étant du platine, et une étape consistant à soumettre le film (16) à un traitement thermique, pour obtenir ainsi le film de métal précieux (12, 18), **caractérisé en ce que** le traitement thermique comprend une étape consistant à exposer le film (12, 18) de platine à une flamme, l'étape d'exposition à une flamme impliquant un chauffage à une température comprise entre 1000 et 1200 °C et exécuté pendant 30 secondes.

2. Procédé selon la revendication 1, dans lequel l'étape d'exposition à une flamme est réalisée au moyen d'une flamme de butane.

3. Procédé selon l'une quelconque des revendications 1 ou 2, dans lequel, après le traitement thermique, le film de métal précieux (12, 18) est soumis à des ultrasons dans un bain de CH₃OH à température ambiante.

4. Procédé selon la revendication 3, dans lequel le film de métal précieux (12, 18) est soumis à des ultrasons pendant au moins 30 minutes, de préférence 40 minutes.

5. Procédé selon l'une quelconque des revendications 1 à 4, dans lequel, après le traitement thermique, le film de métal précieux (12, 18) est immergé dans un bain de CH₃OH à une température d'au moins 50 °C, de préférence de 60 °C.

6. Procédé selon la revendication 5, dans lequel le film de métal précieux (12, 18) est immergé dans le bain de CH₃OH pendant au moins 50 heures, de préférence 70 heures.

7. Procédé selon la revendication 1, dans lequel l'étape de pulvérisation est réalisée dans une atmosphère de gaz inerte.

8. Procédé selon la revendication 1, dans lequel pendant l'étape de pulvérisation le film (12) est placé dans une chambre de pulvérisation (26) comportant une cathode négative (30) qui est faite du métal précieux à pulvériser, et une plaque d'anode (31) sur laquelle le substrat (14) est placé.

9. Procédé selon la revendication 8, dans lequel la chambre (26) est soumise à un vide relatif établi d'environ 1 x 10⁻¹ mbar.

10. Procédé selon l'une quelconque des revendications 1 à 9, dans lequel, avant l'étape de pulvérisation, le substrat (14) est d'abord soumis à des ultrasons puis séché.
